Europäisches Patentamt

European Patent Office

Office européen des brevets

(19)

(11) Veröffentlichungsnummer: **0 283 590**
**A2**

## EUROPÄISCHE PATENTANMELDUNG

(21) Anmeldenummer: 87119409.8

(22) Anmeldetag: 31.12.87

(51) Int. Cl.⁴ **H05K 7/02**

(30) Priorität: 20.10.87 DE 3735455
18.03.87 DE 3708789

(43) Veröffentlichungstag der Anmeldung:
28.09.88 Patentblatt 88/39

(84) Benannte Vertragsstaaten:
AT BE CH FR GB IT LI LU NL

(71) Anmelder: TELENORMA Telefonbau und
Normalzeit GmbH
Mainzer Landstrasse 128-146
D-6000 Frankfurt am Main(DE)

(72) Erfinder: Isert, Hans, Prof. Dr. Ing.
Saalfelderstrasse 33
D-6074 Rödermark(DE)
Erfinder: Schäfer, Wolfgang, Dr. phil. nat.
Altkönigstrasse 3b
D-6368 Bad Vilbel 4(DE)

(54) Elektrische Bauelemente.

(57)

1. Elektronische Schaltungen tragende Substrate wurden bisher durch Kleben miteinander verbunden. Durch die Erfindung soll eine mechanische Verbindung ohne Klebmittel möglich sein.

2. Hierzu werden die Substrate an ihrer Ober- bzw. Unterseite bzw. an den Seitenflächen mit Vorsprüngen (4) bzw. Ausnehmungen (5) versehen, so daß die Substrate (1) und (6) aufeinander bzw. aneinander gesteckt werden können. Über die Vorsprünge (4) und Ausnehmungen (5) können auch elektrische Verbindungen hergestellt werden, wenn dieselben elektrisch leitend ausgebildet sind.

3. Durch die Erfindung lassen sich Substrate auch unterschiedlicher Materialien zusammenfügen, beispielsweise zum Zwecke der Wärmeabfuhr.

EP 0 283 590 A2

## Elektrische Baulemente

Im Laufe der vorangegangenen Jahre haben sich die Abmessungen von elektronischen Baulementen immer mehr verkleinert. Das gilt sowohl für Bauelemente integrierter Halbleitertechnologie als auch für Bauelemente der Dicktschicht-und Dünnschichttechnik. So können beispielsweise die Abmessungen eines Multilayer-Keramikkondensators der Dickschichttechnik oder ein entsprechender Widerstand die Fläche von einem mm² unterschreiten. Entsprechendes gilt für ungekapselte Halbleiterchips.

Die genannten Mikrobauelemente werden daher auf einen Träger aus Metall, Keramik oder Kunststoff aufgebracht, welches durch Legieren, Löten oder Kleben geschehen kann. Näheres hierzu siehe Peter Kästner, "Halbleiter-Technologie, Vogelverlag 1980 und Günter Käs, Schichtelektronik, Lexika-Verlag 1978."

Die Befestigung der genannten Mikrobauelemente auf einem Träger bereitet nun aufgrund der kleinen Abmessungen, die beherrscht werden müssen, erhebliche Schwierigkeiten. In der Regel wird dabei so vorgegangen, daß die der auf-oder eingebrachten elektronischen Schaltungen abgewandte Unterseite auf den Träger aufgebracht wird, an den gleichzeitig in geeigneter Weise aus Metall bestehende elektrische Anschlüsse befestigt sind. Diese Anschlüsse werden mit meist aus Aluminium bestehenden Anschlußpunkten des nackten Chips verbunden (bonden).

Dieser Bondvorgang is sehr aufwendig.

Die Erfindung geht daher aus von einer in dem Gattungsbegriff näher bezeichneten Verbindungstechnik und hat sich zur Aufgabe gestellt, eine für Mikrobauelemente geeignete kostengünstige Verbindungstechnik vorzuschlagen.

Die genannte Aufgabe wird durch die in dem Hauptanspruch ausgeführte Merkmalskombination gelöst. Die Erfindung besteht im Prinzip also darin, die aus der Halbleitertechnik bekannte Ätztechnik auch auf die Schaffung von vorzugsweise lösbaren Verbindungen anzuwenden. Dabei werden durch geeignete Ätztechniken an dem einen der beiden zu verbindenden Elemente Vorsprünge und an dem anderen der beiden zu verbindenen Elemente entsprechende Ausnehmungen herausgearbeitet, so daß die beiden Elemente an ihren miteinander zu verbindenden Seiten ineinander gesteckt werden können. Geeignete Ätztechniken sind aus der Halbleitertechnik hinreichend bekannt. Im Prinzip ist es aus der Literatur auch bekannt, die in der Halbleitertechnik verwendeten Ätztechniken auch zur Lösung mechanischer Probleme anzuwenden (siehe beispielsweise Proceedings of the IEEE, VOL. 70, NO. 5, Mai 1982). Es ist daher möglich die mit Ansätzen versehenen Mikrobauelemente, zu denen auch Halbleiterbauelemente gehören können, auf einen mit entsprechenden Ausnehmungen in Ätztechnik angefertigten Träger aufzustecken. In einigen Fällen kann es aber auch zweckmäßig erscheinen, die Bauelemente selbst mit Ausnehmungen zu versehen und auf dem Träger entsprechende Vorsprünge herauszuarbeiten.

In manchen Fällen, in denen es die Größe der Mikrobauelemente erlaubt, können die Ansätze der Mikrobauelemente auch in Ausnehmungen des Trägers eingreifen, die durch andere Techniken als Ätzen gewonnen wurde, so beispielsweise durch Bohren und durch Ausbrennen mit Hilfe von Laserstrahlen. Diese Technik empfiehlt sich insbesondere bei Träger, die nur schwer oder überhaupt nicht ätzbar sind, wie beispielsweise Kunststoff, oder bestimmte Metalle.

Als Trägermaterial kann das gleiche Material verwendet werden, aus dem das Mikrobauelement selbst auch besteht, wie beispielsweise Silizium, Galliumarsenid, Keramik oder ähnliches. Die gleiche Technik läßt sich aber auch anwenden um zwei oder mehr Mikrobauelemente schichtförmig miteinander zu verbinden. Man erhält hierdurch eine recht hohe Packungsdichte. Außerdem bietet eine derartige Verbindungstechnik den Vorteil, daß in einfacher Weise bereits geprüfte Bauelemente dicht gepackt miteinander verbunden werden können, so daß sich hierdurch eine höhere Ausbeute bei der herzustellenden Schaltung erhoffen läßt. Durch den lösbaren Aufbau ist aber auch eine erhöhte Flexibilität in der Gestaltung der Gesamtschaltung und bei möglichen Reparaturen gegeben.

In vorteilhafter Weiterbildung der Erfindung empfiehlt es sich, die Vorsprünge als stumpfe Kegel und die zugehörigen Ausnehmungen als Zylinder auszugestalten. Die Zylinder können beispielsweise Kreiszylinder sein, mit denen sich die geneigten Mantelflächen der kegelförmigen Vorsprünge bei der Verbindung verklemmen. Zur Erzielung besserer Übergänge können aber auch die Querschnittflächen der Ausnehmungen und der Vorsprünge unterschiedliche geometrische Figuren haben, wie beispielsweise Kreis und Viereck oder ähnliches. Beim Ineinanderstecken ergeben sich hierdurch im wesentlichen linienförmige Verbindungsflächen, die für einen guten mechanischen Kontakt der beiden zu verbindenden Elemente sorgen.

Die geringfügigen Abmessungen der Mikrobauelemente in denen u.U. beachtliche Leistungen umgesetzt werden, bringen es mit sich, daß diese sich unangemessen erwärmen können. In solchen Fällen empfiehlt es sich, daß zwischen den zugewandten Flächen der miteinander zu verbindenden Substrate ein Hohlraum im verbundenen Zustand verbleibt, der zu Kühlungszwecken dient. Die Ausgestaltung der beiden miteinander zu verbindenden Klemmelemente ist dabei derart, daß im verklemmten Zustand ein erheblicher Zwischenraum zwischen den einander zugewandten Substratflächen besteht, wodurch ein kühlendes Medium wie beispielsweise Luft oder Wasser geleitet werden kann. Die Ansätze der auf dem Träger festgesteckten Mikrobauelements wirken dabei gleichzeitig als Abstandspfosten zwischen Träger und Bauelement. Durch eine entsprechende Ausgestaltung von Vorsprüngen und Ausnehmungen lassen sich geeignete Kanäle auch zur Durchführung von Flüssigkeit schaffen.

In Weiterbildung der Erfindung empfiehlt es sich, die Oberflächen von Vorsprüngen und Ausnehmungen mit elektrisch leitenden Schichten zu versehen, so daß hier die Möglichkeit besteht, die Klammverbindung gleichzeitig zur elektrischen Verbindung zweier miteinander zu verbindener elektrischer Schaltungen auszunutzen. Dabei kann die Leitschicht durch Dotieren, Aufdampfen, Diffundieren oder vergleichbare Techniken geschaffen werden. Die Vorsprünge bzw. Ansätze sind mit elektrisch leitenden Bahnen elektrisch leitend verbunden, die zu geeigneten Punkten der Schaltung führen, die auf das Substrat aufgebracht oder in dieses eingebracht ist. Auch der Träger kann wiederum eine eigene elektrische Schaltung besitzen, die auf den Träger aufgebracht oder in diesen eingebracht ist.

Als Ätztechniken empfehlen sich isotropes Ätzen soweit die Vorsprünge oder Ausnehmungen einen runden Querschnitt erhalten sollen und anisotropes Ätzen, so weit die Vorsprünge oder Ausnehmungen einen rechteckförmigen Querschnitt erhalten sollen.

Ein Ausführungsbeispiel der Erfindung wird nachfolgend anhand der Zeichnung erläutert. Darin zeigt

Fig. 1 ein mit Vorsprüngen versehenes Substrat

Fig. 2 einen Träger mit den den Vorsprüngen des Substrats entsprechenden Ausnehmungen.

Fig. 3 das Zusammenfügen zweier Substrate und

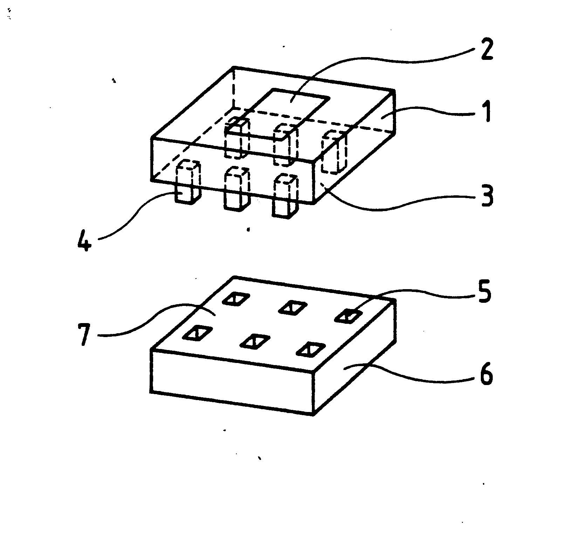

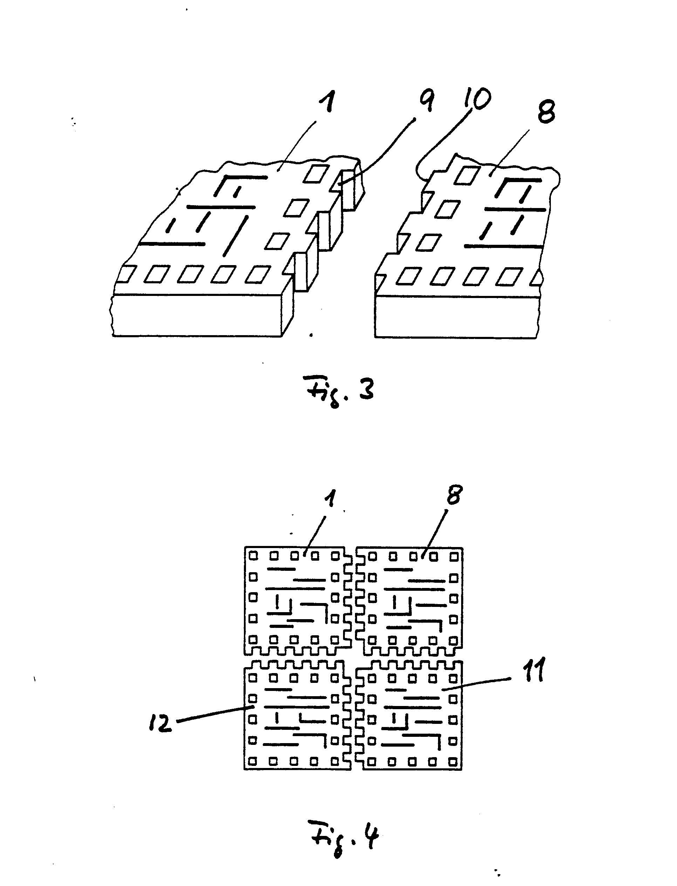

Fig. 4 die mosaikartige Zusammenfügung von mehreren Substraten. Beim dem in Fig. 1 gezeigten Substrat 1 handelt es sich um ein Mikrobauelement, in welches eine elektrische Schaltung 2 in Form einer Halbleiterschaltung eingebracht ist. Das Substrat besteht aus Silizium und besitzt an seinem unteren Ende im wesentlichen quaderförmige Vorsprünge 4, welche mit dem Substrat einstückig verbunden sind oder durch Herausätzen aus dem Siliziumsubstrat geschaffen wurden. Die Vorsprünge 4 sind durch nicht dargestellte sich durch das Substrat ziehende elektrische Leiterbahnen mit geeigneten elektrischen Punkten der angedeuten Schaltung 2 verbunden.

Der Träger 6 besitzt den Vorsprüngen 4 entsprechende Ausnehmungen 5, die sich in die Tiefe gehend konisch verengen. Der Träger 6 kann als Teilausschnitt eines größeren Bauelementes betrachtet werden, oder aber auch als eigenes Mikrobauelement, welches eine eigene für den Betrachter nicht erkennbare elektrische Schaltung 2 trägt, welche sich auf der dem Betrachter abgewandten Seite befindet. So kann beispielsweise der Träger einen große Wafer sein, welcher mehrere Substrate wie in Nummer 1 gezeigt, trägt. Die Innenflächen der Ausnehmungen 5 des Trägers 6 sind in geeigneter Weise mit einer in den Träger 6 eingebrachten elektrischen Leitung oder aber auch nur untereinander in zweckmäßiger Weise verbunden, so daß die Verbindungen wie eine Leiterplattenverdrahtung wirken.

Beim Einstecken des Substrats 1 in den Träger 6 sorgen die in die Ausnehmungen 5 ragenden Vorsprünge 4 nicht nur für eine mechanische Verbindung zwischen den Substraten, sondern auch für eine geeignete elektrische Verbindung. Dabei sind die konischen Neigungswinkel der Ausnehmungen 5 derart gestaltet, daß bei einem Klemmsitz der beiden Substrate zwischen den einander zugewandten Flächen 3 und 7 ein Abstand bleibt, der zu Kühlzwecken ausgenutzt werden kann, indem zwischen den Platten eine Kühlflüssigkeit oder ein kühlender Lulftstrom geführt wird. Die elektrische Verbindung die ggf. auch durch Diffusion der geeigneten Übergangsstellen im verwendeten Halbleitermaterial und nachträglichem Strukturätzen bewirkt werden kann, ist besonders zuverlässig. Die gleichzeitig bewirkte Verbindungstechnik kann eine Platzersparnis bis zu 50% erreichen.

Bei dreidimensionalen Aufbau von IC's aus gleichen oder unterschiedlichen Materialien lassen sich, wie oben schon erläutert, die notwendigen Kontaktierungsstellen und Verbindungswege in das Substrat einbringen und überlange Metallisierungswege vermeiden. Zusätzlich lassen sich als Leiterplattenmaterialien leitbahnstrukuierte Wafer einsetzen, auf die die steckfähigen Mikrobauelemente direkte platziert werden können. Auch die Verbindung unterschiedlicher Trägermaterialien ist möglich, sofern durch entsprechende Ätzprozesse die Materialien zuvor in geeigneter Weise strukuiert worden sind. Die Substrate lassen sich nicht nur verbinden, wenn sie übereinander angeordnet sind, wie dies anhand der Fig. 1 und 2 beschrieben ist, es ist auch eine Verbindung zweier oder mehrerer in einer Ebene liegender Substrate durch die Erfindung möglich, indem die Seitenflächen an den miteinander zu verbindenden Seiten mit Ausnehmungen 9 bzw. Vorsprüngen 10 versehen sind. Über diese Ausnehmungen 9 und Vorsprünge 10 lassen sich zwei oder auch mehrere Substrate lösbar oder fest miteinander verbinden, wobei die auf diese Weise hergestellte Substratanordnung auf einem weiteren Substrat mittels Klebematerial. "anodic bonding" oder mittels auf der Chipunterseite herausgeätzten Vorsprünge befestigt sind, wie dies anhand der Fig. 1 und 2 erläutert ist. Die Herstellung elektrischer Verbindungen zwischen zwei Substrate kann nun wiederum durch Metallisierung der Kontaktstellen an den Ausnehmungen 9 bzw. Vorsprüngen 10 geschehen, wobei die Kontaktstellen mit der elektrischen Schaltung auf dem Substrat verbunden sind. Eine weitere Möglichkeit zur Herstellung elektrischer Verbindungen zwischen zwei in einer Ebene mechanisch miteinander verbundenen Substraten kann auch dadurch geschehen, daß an der Oberseite im Bereich der mit Vorsprüngen 10 bzw. Ausnehmungen 9 versehenen Seitenflächen elektrische Anschlußpunkte vorgesehen sind, welche zum Anschluß von Drähten mittels Schweißen oder Löten dienen. Die mechanische Verbindung zweier Substrate in einer Ebene kann auch zur Wärmeabführung dienen, wobei beispeilsweise auf dem einen Substrat die Wärme entsteht und durch das mechanisch verbundene Substrat die Abstrahlungsfläche vergrößert wird. In diesem Fall sind elektrische Verbindungen nicht unbedingt notwendig. Bei dem in Fig. 4 gezeigten Ausführungsbeispiel wird davon ausgegangen, daß 4 Substrate 1,8,11 und 12 miteinander verbunden werden, um auf diese Weise eine integrierte Schaltung zu bilden. Es wird noch darauf hingewiesen, daß die Substrate nicht unbedingt aus den gleichen sondern auch aus unterschiedlichen Materialien bestehen können, wodurch sich auch integrierte Schaltungen herstellen lassen, die in unterschiedlichen Techniken hergestellt sind.

## Ansprüche

1. Elektrische Bauelemente mit in ein Substrat eingebrachten oder auf das Substrat aufgebrachten elektronischen Schaltungen, die mit einem Träger oder mit einem anderen Bauelement verbunden sind,
dadurch gekennzeichnet,
daß auf der der elektronischen Schaltung abgewandten Seite (3) und/oder an den Seitenflächen des Substrats (1) Ausnehmungen (5,9) bzw. Vorsprünge (4,10) vorgesehen sind, welche in ihrem geometrischen Abmessungen zugeordneten Vorsprüngen bzw. Ausnehmungen eines weiteren Substrats (6,8) entsprechen und daß die beiden Substrate durch Ineinanderfügen der zugehörigen Ausnehmungen (5,9) und Vorsprünge (4,10) miteinander verbindbar sind.

2. Elektrische Bauelemente nach Anspruch 1,
dadurch gekennzeichnet,
daß die Vorsprünge (4) als abestumpfte Kreiskegel und die zugehßrigen Ausnehmungen (5) als kreiszylinderförmige Öffnungen ausgebildet sind.

3. Elektrische Bauelemente nach Anspruch 1,
dadurch gekennzeichnet,
daß die Vorsprünge (4) im wesentlichen durch Kreiszylinder und die zugehörigen Ausnehmungen (6) im wesentlichen durch Rechteckzylinder gebildet sind, oder umgekehrt.

4. Elektrische Bauelemente nach einem der Ansprüche 1 bis 3,
dadurch gekennzeichnet,
daß die Außenflächen der Vorsprünge (4,10) und/oder Ausnehmungen (5,9) derart abgeschrägt sind, daß sie im ineinandergefügten Zustand einen Klemmsitz ergeben.

5. Elektrische Bauelemente nach einem der Ansprüche 1 bis 4,
dadurch gekennzeichnet,
daß im ineinandergefügten Zustand der Vorsprünge (4) und Ausnehmungen (5) die einander zugewandten Grundflächen (3,7) der Substrate (1,6) im Abstand zueinander stehen und die so gebildeten Hohlräume zwischen den Substratflächen (3,7) zu Kühlzwecken dienen.

6. Elektrische Bauelemente nach Anspruch 5,
dadurch gekennzeichnet,
daß die Hohlräume in ihrer Gesamtheit ein Kanalsystem bilden mit einer Eintrittsöffnung und einer Austrittsöffnung, die an einen Kühlkreislauf vorzugsweise Kühlflüssigkeitskreislauf angeschlossen sind.

7. Elektrische Bauelemente nach einem der Ansprüche 1 bis 6,
dadurch gekennzeichnet,
daß die Vorsprünge (4,10) und Ausnehmungen (5,9) mit einer elektrisch leitenden Schicht überzogen oder selbst aus leitendem Material ausgebildet sind, die eine elektrisch leitende Verbindung zu geeigneten Punkten der elektronischen Schaltung aufweisen.

8. Elektrische Bauelemente nach einem der Ansprüche 1 bis 7,
dadurch gekennzeichnet,
daß die Vorsprünge (4,10) bzw. Ausnehmungen (5,9) durch anisotropes Ätzen gebildet sind.

9. Elektrische Bauelemente nach einem der Ansprüche 1 bis 8,
dadurch gekennzeichnet,
daß die zu verbindenden Substrate aus Silizium und/oder Keramik bestehen.

10. Elektrische Bauelemente nach einem der Ansprüche 1 bis 6, oder 8 bis 9,
dadurch gekennzeichnet,
daß an der Oberseite der Substrate (1,8) im Bereich der mit Vorsprüngen (10) bzw. Ausnehmungen (9) versehenen Seitenflächen elektrische Anschlußpunkte vorgesehen sind, welche zur Herstellung von elektrischen Verbindungen zwischen zwei Substraten (1,8) dienen.

11. Elektrische Bauelemente nach Anspruch 10,
dadurch gekennzeichnet,
daß die Verbindung durch an den Anschlußpunkten angeschweißte oder angelötete Drähte erfolget.

12. Elektrische Bauelemente nach einem der Ansprüche 1 bis 11,
dadurch gekennzeichnet,
daß mehrere Seitenflächen eines Substrats mit Vorsprüngen (4,10) bzw. Ausnehmungen (5,9) versehen sind.

13. Elektrische Bauelemente nach einem der Ansprüche 1 bis 12,
dadurch gekennzeichnet,
daß die Substrate aus unterschiedlichen Materialien bestehen.

Fig. 3

Fig. 4

TELENORMA
TN P 4118